# EUROPEAN PATENT APPLICATION

(11) **EP 4 105 982 A1**
(43) Date of publication of application: **21.12.2022**
(21) Application number: 22169613.1
(22) Date of filing: 25.04.2022
(51) Int. Cl.: H01L 23/15, H01L 23/498

(54) **COAXIAL STRUCTURE IN A GLASS SUBSTRATE**

(30) Priority: 17.06.2021 US 202117350169
(71) Applicant: INTEL Corporation, Santa Clara, CA 95054 (US)
(72) Inventor: KAMGAING, Telesphor, Chandler, 85249 (US); STRONG, Veronica, Hillsboro, 97123 (US); DOGIAMIS, Georgios, Chandler, 85226 (US); PRABHU GAUNKAR, Neelam, Chandler, 85225 (US); ALEKSOV, Aleksandar, Chandler, 85286 (US)
(74) Representative: Goddar, Heinz J.

(57) **Abstract**

Embodiments described herein may be related to apparatuses, processes, and techniques related to creating coaxial structures within glass package substrates. These techniques, in embodiments, may be extended to create other structures, for example capacitors within glass substrates. Other embodiments may be described and/or claimed.

## Description

### FIELD

Embodiments of the present disclosure generally relate to the field of semiconductor packaging, and in particular electrical couplings within package substrates.

### BACKGROUND

Continued growth in virtual machines and cloud computing will continue to increase the demand for high-speed I/O within packages and substrates.

### BRIEF DESCRIPTION OF THE DRAWINGS

FIG. 1 illustrates multiple examples of laser-assisted etching of glass interconnects processes, in accordance with embodiments.
FIGs. 2A-2B illustrate legacy implementations of a quasi-coaxial structure within substrate.
FIG. 3 illustrates a top view and a side view of a coaxial structure within a glass substrate, in accordance with various embodiments.
FIGs. 4A-4D illustrate a process flow for creating two coaxial structures within a glass substrate, in accordance with various embodiments.
FIG. 5 illustrates a top view and a side view of a coaxial capacitor structure within a glass substrate, in accordance with various embodiments.
FIGs. 6A-6F illustrate a process flow for creating a capacitor structure within a glass substrate, in accordance with various embodiments.
FIG. 7 illustrates an example process for creating a coaxial structure through a glass substrate, in accordance with various embodiments.
FIG. 8 schematically illustrates a computing device, in accordance with embodiments.

### DESCRIPTION

Embodiments described herein may be related to apparatuses, processes, and techniques for creating coaxial structures within glass package substrates. These techniques, in embodiments, may be extended to create other structures, for example capacitors within glass substrates. These embodiments may provide the ability to control structural impedance, provide complete shielding for a signal, provide a reduced footprint versus legacy approaches, on the order of 10 times area reduction or more. Furthermore, embodiments extend the implementation of coaxial structures to different structures other than transmission lines.

Legacy coaxial structures, such as transmission lines, are widely used for high speed transmission. Coaxial structures provide signal shielding, high integrity and impedance control over a broad frequency band. In embodiments, such coaxial structures may be useful on a package, for example as a signal transitions between a first level interconnect (FLI) and a second level interconnect (SLI).

Coaxial structures may be implemented using laser-assisted etching of glass interconnects to create through glass coaxial structures that have a reduced footprint within a glass substrate. In embodiments, the laser-assisted etching process may be used to build trenches within a glass substrate, but may also be used as a through glass process to combine coaxial and non-coaxial structures on the same substrate.

One or more laser sources followed by wet-etching may be used to create through hole vias or trenches into the glass panel or glass wafer. Using these laser techniques, vias may be created with a small diameter, for example on the order of less than 10 µm, and may be spaced with a pitch on the order of 50 µm or less. Other vias may be created with different diameter sizes. These vias may be later plated for filled to create electrical pathways through the bridge. These techniques may be used to create vias in the glass wafer or panel that have high aspects ratios, for example 40:1 or 50:1. Because of the fine pitch of the vias, more signals may be put through the BGA field at a higher density and may expand the frequency range resulting in a higher bandwidth communications. In addition, these techniques may reduce or eliminate impedance mismatch, which in legacy implementations may limit the frequency bandwidth of signals transmitted through the package BGA interface.

In the following detailed description, reference is made to the accompanying drawings which form a part hereof, wherein like numerals designate like parts throughout, and in which is shown by way of illustration embodiments in which the subject matter of the present disclosure may be practiced. It is to be understood that other embodiments may be utilized and structural or logical changes may be made without departing from the scope of the present disclosure. Therefore, the following detailed description is not to be taken in a limiting sense, and the scope of embodiments is defined by the appended claims and their equivalents.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B and C).

The description may use perspective-based descriptions such as top/bottom, in/out, over/under, and the like. Such descriptions are merely used to facilitate the discussion and are not intended to restrict the application of embodiments described herein to any particular orientation.

The description may use the phrases "in an embodiment," or "in embodiments," which may each refer to one or more of the same or different embodiments. Furthermore, the terms "comprising," "including," "having," and the like, as used with respect to embodiments of the present disclosure, are synonymous.

The term "coupled with," along with its derivatives, may be used herein. "Coupled" may mean one or more of the following. "Coupled" may mean that two or more elements are in direct physical or electrical contact. However, "coupled" may also mean that two or more elements indirectly contact each other, but yet still cooperate or interact with each other, and may mean that one or more other elements are coupled or connected between the elements that are said to be coupled with each other. The term "directly coupled" may mean that two or more elements are in direct contact.

Various operations may be described as multiple discrete operations in turn, in a manner that is most helpful in understanding the claimed subject matter. However, the order of description should not be construed as to imply that these operations are necessarily order dependent.

As used herein, the term "module" may refer to, be part of, or include an ASIC, an electronic circuit, a processor (shared, dedicated, or group) and/or memory (shared, dedicated, or group) that execute one or more software or firmware programs, a combinational logic circuit, and/or other suitable components that provide the described functionality.

Various Figures herein may depict one or more layers of one or more package assemblies. The layers depicted herein are depicted as examples of relative positions of the layers of the different package assemblies. The layers are depicted for the purposes of explanation, and are not drawn to scale. Therefore, comparative sizes of layers should not be assumed from the Figures, and sizes, thicknesses, or dimensions may be assumed for some embodiments only where specifically indicated or discussed.

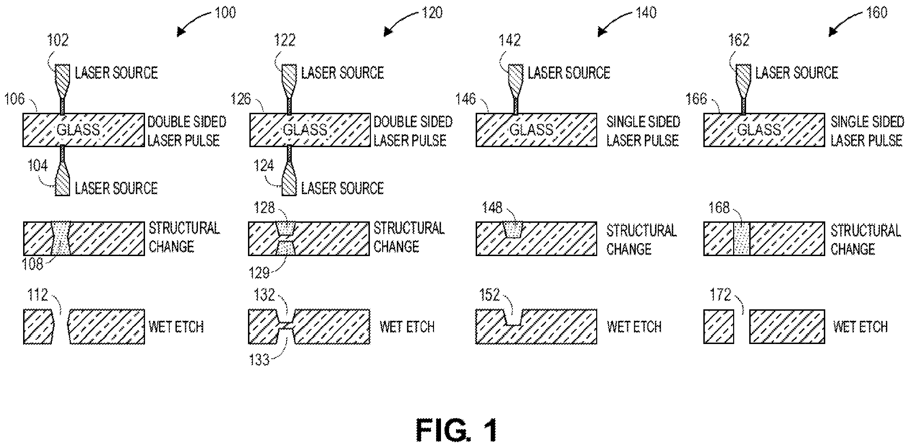

FIG. 1 illustrates multiple examples of laser-assisted etching of glass interconnects processes (which may be referred to as "LEGIT" herein), in accordance with embodiments. One use of the LEGIT technique is to provide an alternative substrate core material to the legacy copper clad laminate (CCL) core used in semiconductor packages used to implement products such as servers, graphics, clients, 5G, and the like. By using laser-assisted etching, crack free, high density via drills, hollow shapes may be formed into a glass substrate. In embodiments, different process parameters may be adjusted to achieve drills of various shapes and depths, thus opening the door for innovative devices, architectures, processes, and designs in glass. Embodiments, such as the bridge discussed herein, may also take advantage of these techniques.

Diagram 100 shows a high level process flow for a through via and blind via (or trench) in a microelectronic package substrate (e.g. glass) using LEGIT to create a through via or a blind via. A resulting volume/shape of glass with laser-induced morphology change that can then be selectively etched to create a trench, a through hole or a void that can be filled with conductive material. A through via 112 is created by laser pulses from two laser sources 102, 104 on opposite sides of a glass wafer 106. As used herein, a through drill and a through via refers to when the drill or the via starts on one side of the glass/substrate and ends on the other side. A blind drill and a blind via refers to when the drill or the via starts on the surface of the substrate and stops partially inside the substrate. In embodiments, the laser pulses from the two laser sources 102, 104 are applied perpendicularly to the glass wafer 106 to induce a morphological change 108, which may also be referred to as a structural change, in the glass that encounters the laser pulses. This morphological change 108 includes changes in the molecular structure of the glass to make it easier to etch out (remove a portion of the glass). In embodiments, a wet etch process may be used.

Diagram 120 shows a high level process flow for a double blind shape. A double blind shape 132, 133 may be created by laser pulses from two laser sources 122, 124, which may be similar to laser sources 102, 104, that are on opposite sides of the glass wafer 126, which may be similar to glass wafer 106. In this example, adjustments may be made in the laser pulse energy and/or the laser pulse exposure time from the two laser sources 122, 124. As a result, morphological changes 128, 129 in the glass 126 may result, with these changes making it easier to etch out portions of the glass. In embodiments, a wet etch process may be used.

Diagram 140 shows a high level process flow for a single-blind shape, which may also be referred to as a trench. In this example, a single laser source 142 delivers a laser pulse to the glass wafer 146 to create a morphological change 148 in the glass 146. As described above, these morphological changes make it easier to etch out a portion of the glass 152. In embodiments, a wet etch process may be used.

Diagram 160 shows a high level process flow for a through via shape. In this example, a single laser source 162 applies a laser pulse to the glass 166 to create a morphological change 168 in the glass 166, with the change making it easier to etch out a portion of the glass 172. As shown here, the laser pulse energy and/or laser pulse exposure time from the laser source 162 has been adjusted to create an etched out portion 172 that extends entirely through the glass 166.

With respect to FIG. 1, although embodiments show laser sources 102, 104, 122, 124, 142, 162 as perpendicular to a surface of the glass 106, 126, 146, 166, in embodiments, the laser sources may be positioned at an angle to the surface of the glass, with pulse energy and/or pulse exposure time variations in order to cause a diagonal via or a trench, or to shape the via, such as 112, 172, for example to make it cylindrical, tapered, or include some other feature. In addition, varying the glass type may also cause different features within a via or a trench as the etching of glass is strongly dependent on the chemical composition of the glass.

In embodiments using the process described with respect to FIG. 1, through hole vias 112, 172 may be created that are less than 10 µm in diameter, and may have an aspect ratio of 40:1 to 50:1. As a result, a far higher density of vias may be placed within the glass and be placed closer to each other at a fine pitch. In embodiments, this pitch may be 50 µm or less. After creating the vias or trenches, a metallization process may be applied in order to create a conductive pathway through the vias or trenches, for example a plated through hole (PTH). Using these techniques, finer pitch vias will result in better signaling, allowing more I/O signals to be put through the glass wafer and to other coupled components such as a substrate.

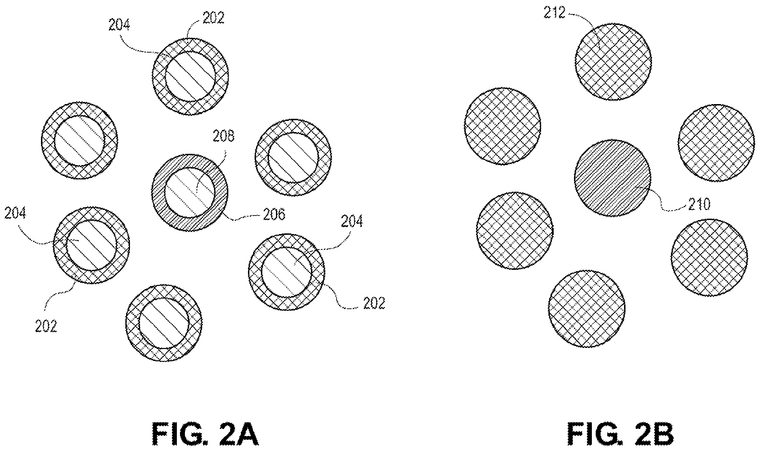

FIGs. 2A-2B illustrate legacy implementations of a quasi-coaxial structure within a substrate. FIG. 2A shows a top-down view of a quasi-coaxial structure that includes a plated through via 208 that carries a signal line 206, that is surrounded by a plurality of plated through vias 202 that are electrically coupled with a ground 204. The number of plated through vias 202 and their distance relative to the signal line 206, are used to partially provide the function of a continuous shielded element that would be found in a traditional coaxial structure. In legacy implementations, filled vias may be used in a thin core, for example cores with a thickness of less than 250 µm. In general, unfilled vias may be used or may be widely used for thick cores.

Similarly, FIG. 2B shows a filled via 210 used for a signal that is surrounded by filled vias 212. Here, the vias 210, 212 may be filled with conductive material such as copper or a copper alloy. In legacy implementations, filled vias may be used in a thin core, for example a core with a thickness of less than 200 µm. the legacy implementations show with respect to FIGs. 2A-2B use a substantial portion of real estate on the package. In addition, they are also susceptible to signal leakage and bandwidth limitation as result of the multiple signal reflections.

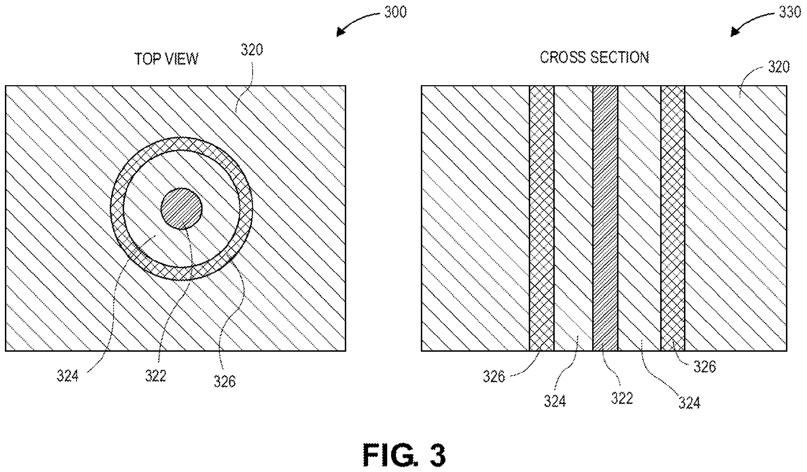

FIG. 3 illustrates a top view and a side view of a coaxial structure within a glass substrate, in accordance with various embodiments. Coaxial structure 300 shows a top view looking down into the top of a glass substrate 320. An inner conductor 322, which may be used to carry signals, is surrounded by an outer conductor 326 in a coaxial fashion. In embodiments, the outer conductor 326 is concentric to the inner conductor 322. In embodiments, the inner conductor 322 and the outer conductor 326 may be separated by a glass material 324, which may be the same glass material as the glass material in substrate 320. In embodiments, a different kind of glass may be used for the glass substrate 320. In embodiments, the thickness of the outer conductor 326 may range from 10 µm to 50 µm. in embodiments, the outer conductor 326 may be conducted to an electrical ground (not shown), but may be electrically coupled to a package ground reference to which the glass substrate 320 is electrically coupled. Coaxial structure 330, which may be the same as coaxial structure 300, shows a cross-section that includes the inner conductor 322 and the outer conductor 326. Glass 324 separates the outer conductor 326 from the inner conductor 322. In embodiments, there may be multiple inner conductors (not shown), similar to inner conductor 322, within the outer conductor 326.

In other embodiments (not shown), the outer conductor and the associated via may have a different shape, such as a non-circular shape that may include a square, rectangular or any irregular closed loop. In other embodiments, the outer conductor may not be a closed loop or may be discontinued at different locations.

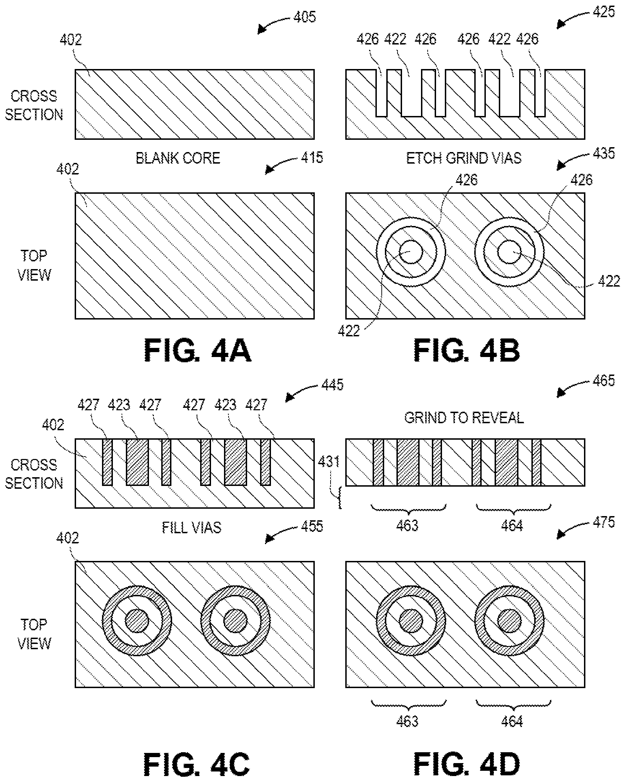

FIGs. 4A-4D illustrate a process flow for creating two coaxial structures within a glass substrate, in accordance with various embodiments. FIG. 4A shows a blank core 402 in a cross-section view 405, as well as a blank core 402 in the top view 415. In embodiments, the blank core 402 is a blank glass core.

FIG. 4B includes signal etches 422, which may be similar to etches used to place the first conductor 322 of FIG. 3, and ground etches 426, which may be similar to etches used to place the second conductor 426 of FIG. 3. Diagram 425 shows a side view, with diagram 435 showing a top view. The etches 422, 426 may be performed by using blind etch techniques described above with respect to FIG. 1, as well as techniques described elsewhere herein. As shown, the ground etches 426 may be concentric with respect to signal etch 422. As shown in diagram 435, the ground etches 426 may have a circular shape. However, in other embodiments, the ground etches 426 may take a shape of a polygon, or of an irregular or discontinuous shape as discussed above.

FIG. 4C shows the ground etches 426 of FIG. 4B filled with conductive material 427 to create a concentric ground layer, and signal etch 422 of FIG. 4B filled with the conductive material 423 to create the signal conductor. Diagram 445 shows a cross-section and diagram 455 shows a top-down view. In embodiments, the conductive material 423, 427 may include copper, gold, tin, aluminum, or some other metal alloy.

FIG. 4D shows a portion 431 of the bottom side of the core 402 that has been ground away to expose the conductive material 423, 427 on both sides of the core 402 thus creating a first coaxial structure 463 and a second coaxial structure 464. Diagram 465 shows a cross-section, and diagram 475 shows a top down view after the grinding. In embodiments, other devices, for example capacitors or inductors, may be fabricated in the glass core 402 using the fabrication process flow described with respect to FIGs. 4A-4D. Additionally, other materials for the concentric ground layer may be used, for example, a ferrite may be used for electromagnetic interference (EMI) shielding. In embodiments, the elemental composition of ferrites may include various allotropes of iron (Fe), such as Barium ferrite (BaFe₁₂O₁₉).

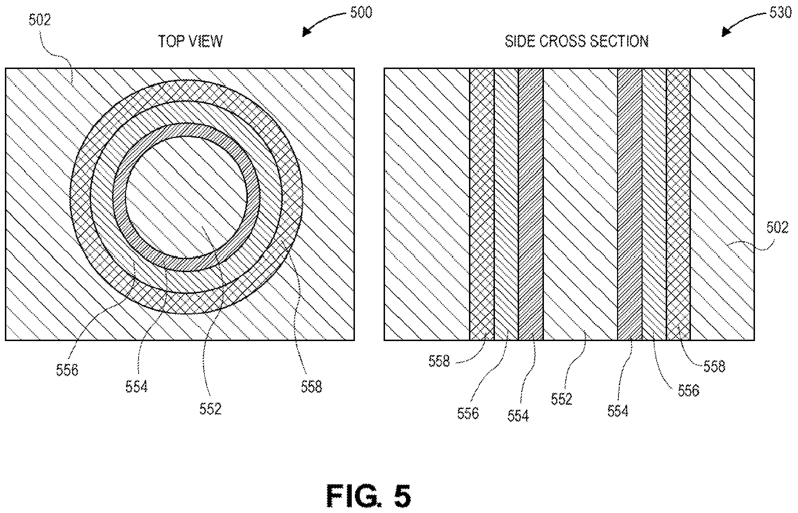

FIG. 5 illustrates a top view and a side view of a coaxial capacitor structure within a glass substrate, in accordance with various embodiments. A top-down view 500 and a side cross-section view 530 of a capacitor structure is shown in FIG. 5. Glass core 502, which may be similar to glass core 402 of FIG. 4, is etched and filled with various materials to create a capacitor structure. The capacitor structure is used to store an electric charge, and includes one or more pairs of conductors that are separated by an insulator or a dielectric.

Capacitor structure 500 shows a glass center 552, which may be part of the glass core 502, surrounded by a first electrode 554. First electrode 554 is surrounded by a dielectric 556, which may be a high-k dielectric. The dielectric 556 may include SiO₂, Si3N4, HfO2, HfZrO2, Ti02, ZrO2, SrTiO2, BaTiO2, and/or BaSrTiO2. The dielectric 556 is surrounded by a second electrode 558, which in turn may be surrounded by more of the glass core 502. In embodiments, the glass center 552, first electrode 554, dielectric 556, and second electrode 558 may be concentric structures. In embodiments, they may be circular as shown, or they may be polygonal, or may be an irregular shape. In embodiments, the etches created in which to place the first electrode 554, the dielectric 556, and the second electrode 558 may be created using techniques described above in FIG. 1, and elsewhere herein.

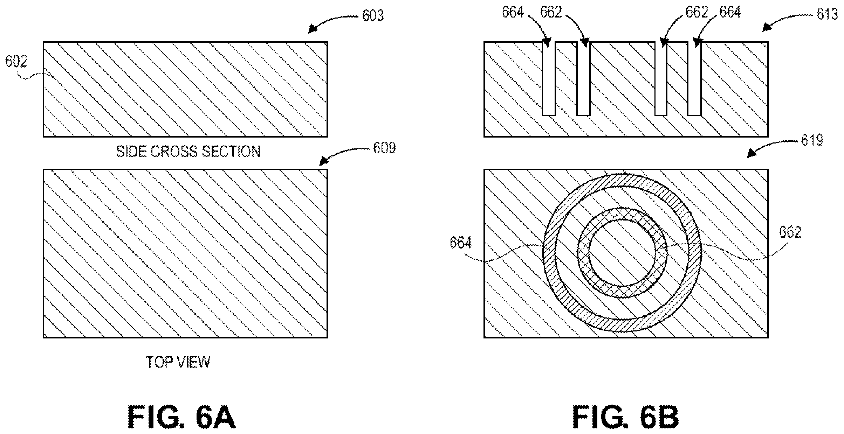

FIGs. 6A-6F illustrate a process flow for creating a capacitor structure within a glass substrate, in accordance with various embodiments. FIG. 6A illustrates a blank core 602 in a cross-section view 603, as well as a top view 609. In embodiments, the blank core 602 is a blank glass core.

FIG. 6B includes a side cross-section 613 and a top-down view 619 that illustrates a first etch 662 for placement of the first electrode which may be similar to first electrode 554 of FIG. 5, and a second etch 664 for the placement of the second electrode, which may be similar to second electrode 558 of FIG. 5. These etches may be created using techniques described above with respect to FIG. 1.

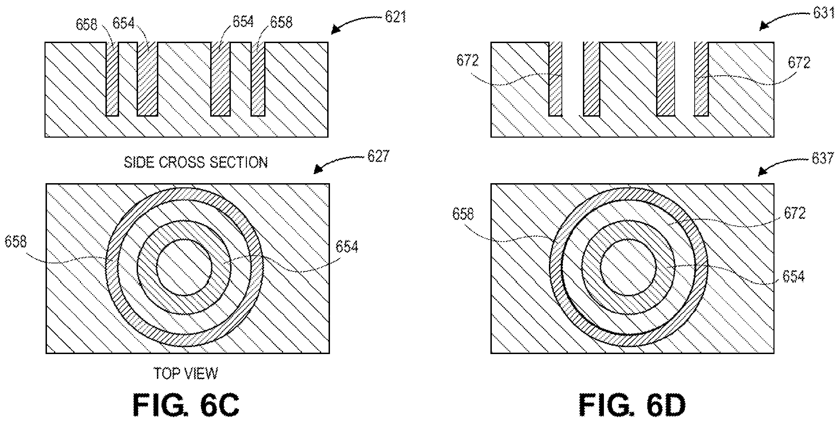

FIG. 6C includes a side cross-section 621 and a top-down view 627 that illustrates depositing of a conductive material in the first etch 662 of FIG. 6B to form the first electrode 654, which may be similar to first electrode 554 of FIG. 5. The conductive material is also deposited in the second etch 664 of FIG. 6B to form the second electrode 658, which may be in a similar to second electrode 558 of FIG. 5.

FIG. 6D includes a side cross-section 631 and a top-down view 637 that illustrates a third etch 672 of glass material between the first electrode 654 and the second electrode 658. In embodiments, the third etch 672 may be performed using the etching techniques described above with respect to FIG. 1. In embodiments, the third etch 672 will expose the sides of the first electrode 654 and the second electrode 658.

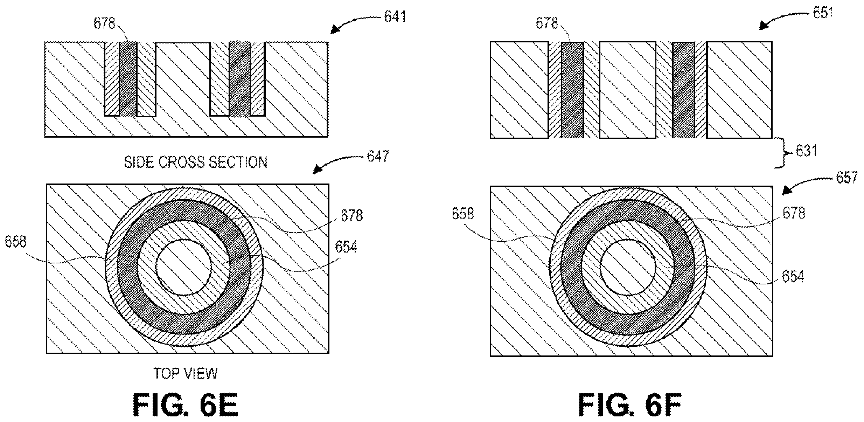

FIG. 6E includes a side cross-section 641 and a top-down view 647 that illustrates a depositing of a dielectric 678 inside the third etch 672 of FIG. 6D. In embodiments, the dielectric 678 is placed in physical contact with the first electrode 654 and the second electrode 658. In embodiments, the dielectric 678 may be a high-k dielectric.

FIG. 6F includes a side cross-section 651 and a top-down view 657 that illustrates the result of grinding on a bottom side of the glass substrate 602. In embodiments, a section 631 may be removed from the bottom of the glass core 602, exposing the first electrode 654, the dielectric 678, and the second electrode 658 to both the top and the bottom of the glass core 602.

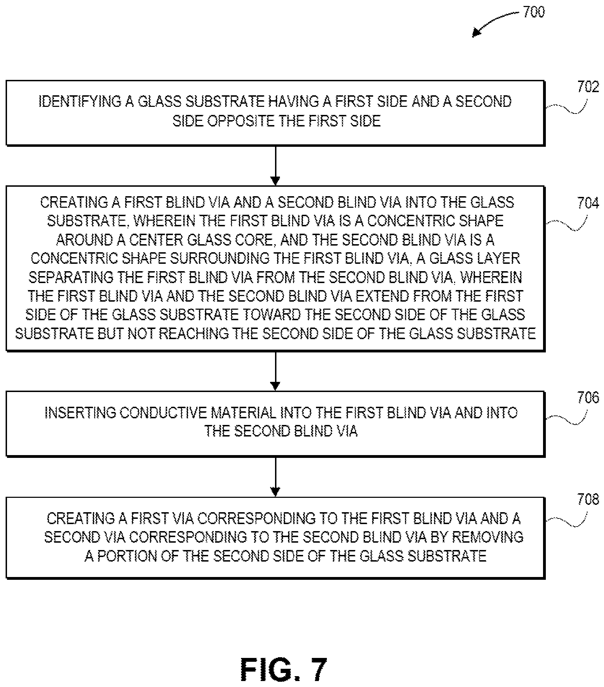

FIG. 7 illustrates an example process for creating a coaxial structure through a glass substrate, in accordance with various embodiments. Process 700 may be implemented using the processes, techniques, apparatus, and/or systems described with respect to FIGs. 1-6 herein.

At block 702, the process may include identifying a glass substrate having a first side and a second side opposite the first side. In embodiments, the glass substrate may be similar to glass substrate 106, 126, 146, 166 of FIG. 1, glass substrate 320 of FIG. 3, or substrate 402 of FIGs. 4A-4D.

At block 704, the process may further include creating a first blind via and a second blind via into the glass substrate, wherein the first blind via is a concentric shape around a center glass core, and the second blind via is a concentric shape surrounding the first blind via, a glass layer separating the first blind via from the second blind via, wherein the first blind via and the second blind via extend from the first side of the glass substrate toward the second side of the glass substrate but not reaching the second side of the glass substrate. In embodiments, the first blind via may be similar to etching 426 of FIG. 4B, and the second blind via may be similar to etching 422 of FIG. 4B.

At block 706, the process may further include inserting conductive material into the first blind via and into the second blind via. In embodiments, the conductive material may be similar to conductive material 423, 427 of FIG. 4C.

At block 708, the process may further include creating a first via corresponding to the first blind via and a second via corresponding to the second blind via by removing a portion of the second side of the glass substrate. In embodiments, the removed portion of the second side of the glass substrate may correspond to removed portion 431 of FIG. 4D. In embodiments, removing a portion of the second side of the glass substrate may include grinding the second side of the glass substrate.

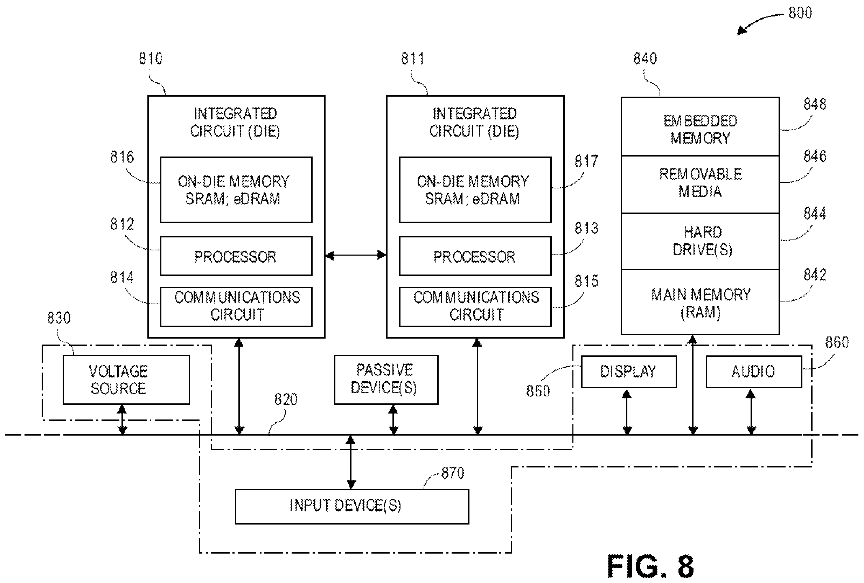

FIG. 8 schematically illustrates a computing device, in accordance with embodiments. The computer system 800 (also referred to as the electronic system 800) as depicted can embody all or part of a coaxial structure in a glass substrate, according to any of the several disclosed embodiments and their equivalents as set forth in this disclosure. The computer system 800 may be a mobile device such as a netbook computer. The computer system 800 may be a mobile device such as a wireless smart phone. The computer system 800 may be a desktop computer. The computer system 800 may be a hand-held reader. The computer system 800 may be a server system. The computer system 800 may be a supercomputer or high-performance computing system.

In an embodiment, the electronic system 800 is a computer system that includes a system bus 820 to electrically couple the various components of the electronic system 800. The system bus 820 is a single bus or any combination of busses according to various embodiments. The electronic system 800 includes a voltage source 830 that provides power to the integrated circuit 810. In some embodiments, the voltage source 830 supplies current to the integrated circuit 810 through the system bus 820.

The integrated circuit 810 is electrically coupled to the system bus 820 and includes any circuit, or combination of circuits according to an embodiment. In an embodiment, the integrated circuit 810 includes a processor 812 that can be of any type. As used herein, the processor 812 may mean any type of circuit such as, but not limited to, a microprocessor, a microcontroller, a graphics processor, a digital signal processor, or another processor. In an embodiment, the processor 812 includes, or is coupled with, all or part of a high-speed bridge between a package and a component, as disclosed herein. In an embodiment, SRAM embodiments are found in memory caches of the processor. Other types of circuits that can be included in the integrated circuit 810 are a custom circuit or an application-specific integrated circuit (ASIC), such as a communications circuit 814 for use in wireless devices such as cellular telephones, smart phones, pagers, portable computers, two-way radios, and similar electronic systems, or a communications circuit for servers. In an embodiment, the integrated circuit 810 includes on-die memory 816 such as static random-access memory (SRAM). In an embodiment, the integrated circuit 810 includes embedded on-die memory 816 such as embedded dynamic random-access memory (eDRAM).

In an embodiment, the integrated circuit 810 is complemented with a subsequent integrated circuit 811. Useful embodiments include a dual processor 813 and a dual communications circuit 815 and dual on-die memory 817 such as SRAM. In an embodiment, the dual integrated circuit 810 includes embedded on-die memory 817 such as eDRAM

In an embodiment, the electronic system 800 also includes an external memory 840 that in turn may include one or more memory elements suitable to the particular application, such as a main memory 842 in the form of RAM, one or more hard drives 844, and/or one or more drives that handle removable media 846, such as diskettes, compact disks (CDs), digital variable disks (DVDs), flash memory drives, and other removable media known in the art. The external memory 840 may also be embedded memory 848 such as the first die in a die stack, according to an embodiment.

In an embodiment, the electronic system 800 also includes a display device 850, an audio output 860. In an embodiment, the electronic system 800 includes an input device such as a controller 870 that may be a keyboard, mouse, trackball, game controller, microphone, voice-recognition device, or any other input device that inputs information into the electronic system 800. In an embodiment, an input device 870 is a camera. In an embodiment, an input device 870 is a digital sound recorder. In an embodiment, an input device 870 is a camera and a digital sound recorder.

As shown herein, the integrated circuit 810 can be implemented in a number of different embodiments, including all or part of a coaxial structure in a glass substrate, according to any of the several disclosed embodiments and their equivalents, an electronic system, a computer system, one or more methods of fabricating an integrated circuit, and one or more methods of fabricating an electronic assembly that includes a package substrate implementing all or part of a coaxial structure in a glass substrate, according to any of the several disclosed embodiments as set forth herein in the various embodiments and their art-recognized equivalents. The elements, materials, geometries, dimensions, and sequence of operations can all be varied to suit particular I/O coupling requirements including array contact count, array contact configuration for a microelectronic die embedded in a processor mounting substrate according to any of the several disclosed processes used for a coaxial structure in a glass substrate embodiments and their equivalents. A foundation substrate may be included, as represented by the dashed line of FIG. 8. Passive devices may also be included, as is also depicted in FIG. 8.

Various embodiments may include any suitable combination of the above-described embodiments including alternative (or) embodiments of embodiments that are described in conjunctive form (and) above (e.g., the "and" may be "and/or"). Furthermore, some embodiments may include one or more articles of manufacture (e.g., non-transitory computer-readable media) having instructions, stored thereon, that when executed result in actions of any of the above-described embodiments. Moreover, some embodiments may include apparatuses or systems having any suitable means for carrying out the various operations of the above-described embodiments.

The above description of illustrated embodiments, including what is described in the Abstract, is not intended to be exhaustive or to limit embodiments to the precise forms disclosed. While specific embodiments are described herein for illustrative purposes, various equivalent modifications are possible within the scope of the embodiments, as those skilled in the relevant art will recognize.

These modifications may be made to the embodiments in light of the above detailed description. The terms used in the following claims should not be construed to limit the embodiments to the specific implementations disclosed in the specification and the claims. Rather, the scope of the invention is to be determined entirely by the following claims, which are to be construed in accordance with established doctrines of claim interpretation.

The following paragraphs describe examples of various embodiments.

### EXAMPLES

Example 1 is a package comprising: a glass substrate having a first side and a second side opposite the first side; and a coaxial structure extending from the first side of the glass substrate to the second side of the glass substrate, the coaxial structure including: a first conductor at a center of the coaxial structure and extending from the first side of the glass substrate to the second side of the glass substrate, a second conductor surrounding the first conductor, the second conductor extending from the first side of the glass substrate to the second side of the glass substrate, and a portion of the glass substrate located between the first conductor and the second conductor.

Example 2 may include the package of example 1, wherein the layer of glass substrate between the first conductor and the second conductor electrically isolates the first conductor and the second conductor.

Example 3 may include the package of example 1, wherein the first conductor is a signal conductor and the second conductor is a ground conductor.

Example 4 may include the package of example 1, wherein the first conductor in the second conductor include copper or a copper alloy.

Example 5 may include the package of example 1, wherein a diameter of the first conductor is at least 10 µm.

Example 6 may include the package of example 1, wherein a thickness of the second conductor ranges from 10 µm to 50 µm.

Example 7 may include the package of example 1, wherein the second conductor surrounding the first conductor is concentric to the first conductor.

Example 8 may include the package of example 7, wherein the second conductor concentric to the first conductor further includes a shape of the conductor concentric to the first conductor in a selected one of: a circle, a polygon, or an irregular shape.

Example 9 may include the package of example 1, wherein the coaxial structure further includes a third conductor proximate to the first conductor and surrounded by the second conductor.

Example 10 may include the package of example 1, wherein the portion of the glass substrate located between the first conductor in the second conductor is a first portion of the glass substrate; and further comprising: a second portion of the glass substrate within the first conductor, the second portion of the glass substrate extending from the first side of the glass substrate to the second side of the glass substrate.

Example 11 may include the package of example 1, wherein one or more walls of the first conductor or the second conductor are tapered from the first side of the substrate to the second side of the substrate.

Example 12 is a capacitor, comprising: a glass substrate having a first side and a second side opposite the first side; and a coaxial structure extending from the first side of the glass substrate to the second side of the glass substrate, the coaxial structure including: a first conductor at a center of the coaxial structure and extending from the first side of the glass substrate to the second side of the glass substrate, a first dielectric located within the first conductor and extending from the first side of the glass substrate to the second side of the glass substrate, a second conductor surrounding the first conductor, the second conductor extending from the first side of the glass substrate to the second side of the glass substrate, and a second dielectric located between the first conductor and the second conductor, the second dielectric extending from the first side of the glass substrate to the second side of the glass substrate.

Example 13 may include the capacitor of example 12, wherein the first conductor or the second conductor include a selected one of: copper, gold, aluminum.

Example 14 may include the capacitor of example 12, wherein the first dielectric is a portion of the glass substrate.

Example 15 may include the capacitor of example 12, wherein the second dielectric comprises at least one of Hf, Zr, Ti, Sr, Ba, and/or Fe.

Example 16 may include the capacitor of any one of examples 12-15, wherein the first conductor and the second conductor are concentric.

Example 17 is a system comprising: a glass substrate having a first side and a second side opposite the first side; a buildup layer on the first side of the glass substrate; and wherein the glass substrate includes a coaxial structure extending from the first side of the glass substrate to the second side of the glass substrate, the coaxial structure including: a first conductor at a center of the coaxial structure and extending from the first side of the glass substrate to the second side of the glass substrate, a second conductor surrounding the first conductor, the second conductor extending from the first side of the glass substrate to the second side of the glass substrate, and a portion of the glass substrate located between the first conductor and the second conductor.

Example 18 may include the system of example 17, wherein the buildup layer includes a redistribution layer (RDL), wherein the RDL is electrically coupled with the first conductor and the second conductor.

Example 19 may include the system of example 17, wherein the first conductor is a signal conductor, and the second conductor is a ground.

Example 20 may include the system of any one of examples 17-19, wherein the buildup layer is a first buildup layer, and further including: a second buildup layer on the second side of the glass substrate, wherein the second buildup layer includes an RDL that is electrically coupled with the first conductor in the second conductor.

Example 21 may include the system of example 20, wherein the coaxial structure provides high-bandwidth communication between the first buildup layer and the second buildup layer.

Example 22 is a method comprising: identifying a glass substrate having a first side and a second side opposite the first side; creating a first blind via and a second blind via into the glass substrate, wherein the first blind via is a concentric shape around a center glass core, and the second blind via is a concentric shape surrounding the first blind via, a glass layer separating the first blind via from the second blind via, wherein the first blind via and the second blind via extend from the first side of the glass substrate toward the second side of the glass substrate but not reaching the second side of the glass substrate; inserting conductive material into the first blind via and into the second blind via; and creating a first via corresponding to the first blind via and a second via corresponding to the second blind via by removing a portion of the second side of the glass substrate.

Example 23 may include the method of example 22, wherein inserting conductive material into the first via and into the second via further includes a selected one of: conformally plating the conductive material onto a wall of the first blind via and the second blind via or filling the first blind via and filling the second of blind via with conductive material.

Example 24 may include the method of example 23, wherein creating the first blind via in the second blind via into the glass substrate further includes etching the first blind via and etching the second blind via using laser-assisted etching of glass interconnects techniques.

Example 25 may include the method of example 23, further comprising, after inserting conductive material: etching the glass layer between the first of blind via and the second blind via; and inserting a dielectric material in the etched glass layer to electrically separate the conductive material in the first blind via from the conductive material in the second blind via.

Example 26 may include the method of any one of examples 22-25, wherein the conductive material includes a selected one of: copper, gold, aluminum.

## Claims

1. A package comprising:
a glass substrate having a first side and a second side opposite the first side; and
a coaxial structure extending from the first side of the glass substrate to the second side of the glass substrate, the coaxial structure including:
a first conductor at a center of the coaxial structure and extending from the first side of the glass substrate to the second side of the glass substrate,
a second conductor surrounding the first conductor, the second conductor extending from the first side of the glass substrate to the second side of the glass substrate, and
a portion of the glass substrate located between the first conductor and the second conductor.

2. The package of claim 1, wherein the layer of glass substrate between the first conductor and the second conductor electrically isolates the first conductor and the second conductor.

3. The package of claim 1 or 2, wherein the first conductor is a signal conductor and the second conductor is a ground conductor.

4. The package of claim 1, 2 or 3, wherein the first conductor in the second conductor include copper or a copper alloy.

5. The package of claim 1, 2, 3 or 4, wherein a diameter of the first conductor is at least 10 µm.

6. The package of claim 1, 2, 3, 4 or 5, wherein a thickness of the second conductor ranges from 10 µm to 50 µm.

7. The package of claim 1, 2, 3, 4, 5 or 6, wherein the second conductor surrounding the first conductor is concentric to the first conductor.

8. The package of claim 7, wherein the second conductor concentric to the first conductor further includes a shape of the conductor concentric to the first conductor in a selected one of: a circle, a polygon, or an irregular shape.

9. The package of claim 1, 2, 3, 4, 5, 6, 7 or 8, wherein the coaxial structure further includes a third conductor proximate to the first conductor and surrounded by the second conductor.

10. The package of claim 1, wherein the portion of the glass substrate located between the first conductor in the second conductor is a first portion of the glass substrate; and further comprising:
a second portion of the glass substrate within the first conductor, the second portion of the glass substrate extending from the first side of the glass substrate to the second side of the glass substrate.

11. The package of claim 1, 2, 3, 4, 5, 6, 7, 8, 9 or 10, wherein one or more walls of the first conductor or the second conductor are tapered from the first side of the substrate to the second side of the substrate.

12. A method comprising:
identifying a glass substrate having a first side and a second side opposite the first side;
creating a first blind via and a second blind via into the glass substrate, wherein the first blind via is a concentric shape around a center glass core, and the second blind via is a concentric shape surrounding the first blind via, a glass layer separating the first blind via from the second blind via, wherein the first blind via and the second blind via extend from the first side of the glass substrate toward the second side of the glass substrate but not reaching the second side of the glass substrate;
inserting conductive material into the first blind via and into the second blind via; and
creating a first via corresponding to the first blind via and a second via corresponding to the second blind via by removing a portion of the second side of the glass substrate.

13. The method of claim 12, wherein inserting conductive material into the first via and into the second via further includes a selected one of: conformally plating the conductive material onto a wall of the first blind via and the second blind via or filling the first blind via and filling the second of blind via with conductive material.

14. The method of claim 13, wherein creating the first blind via in the second blind via into the glass substrate further includes etching the first blind via and etching the second blind via using laser-assisted etching of glass interconnects techniques.

15. The method of claim 13, further comprising, after inserting conductive material:
etching the glass layer between the first of blind via and the second blind via; and inserting a dielectric material in the etched glass layer to electrically separate the conductive material in the first blind via from the conductive material in the second blind via.
